# EUROPEAN PATENT APPLICATION

(11) **EP 4 611 516 A1**
(43) Date of publication of application: **03.09.2025**
(21) Application number: 24198612.4
(22) Date of filing: 05.09.2024
(51) Int. Cl.: H10K 59/131, H10K 71/70, G02F 1/1362, G09G 3/32, G06F 3/041

(54) **DISPLAY DEVICE**

(30) Priority: 27.02.2024 KR 20240028350
(71) Applicant: LG Display Co., Ltd., Seoul 07336 (KR)
(72) Inventor: LEE, Geonwoo, 10845 Paju-si, Gyeonggi-do (KR); KIM, Minkyu, 10845 Paju-si, Gyeonggi-do (KR)
(74) Representative: Viering, Jentschura & Partner mbB Patent- und Rechtsanwälte

(57) **Abstract**

Disclosed is a display device (1) in which a capping layer (CL) surrounding an open area (OA) and including a metal material is disposed on an intermediate area (MA) between a display area (AA) and the open area (OA), thereby preventing moisture penetration from a position on top of an insulating layer through the insulating layer near the open area (OA).

## Description

### BACKGROUND

### Field

The present disclosure relates to a display device including an open area in a display area.

### Description of Related Art

A display device is implemented in a variety of forms such as televisions, monitors, smart phones, tablet PCs, laptops, and wearable devices.

A display device may display an image via a plurality of pixels included in a display area.

With the advancement of technology, the display device may provide a shooting function or a sensing function using various optical sensors in addition to a function of displaying the image.

To implement these functions, the display device may include various types of optical devices such as a camera or a detection sensor.

The display device includes a bezel area outside the display area, and the camera and the detection sensor may be disposed in the bezel area.

### SUMMARY

As user demand for a display device with a bezel-less or bezel-free design that may reduce the bezel area as much as possible and increase the display area as much as possible increases, it may become difficult to place the camera and the sensor in the bezel area.

Accordingly, various technologies have been designed to place the camera and the sensor in the display area of the display device.

A scheme has been devised to define an open area such as a hole where the camera and the detection sensor may be disposed in the display area. This scheme is referred to as Hole-in Display (HID) or Hole-in-Active Area (HiAA).

When the open area is formed within the display area, various insulating layers and light-emitting layers as well as a substrate of a display panel may be partially removed to prevent interference with the camera and the detection sensor positioned in the open area.

In one of schemes of partially removing the substrate of the display panel to form the open area, a precise cutting process using laser may usually be performed.

When the precise cutting process using the laser is performed in this way, a large amount of energy is accumulated in a local area of the substrate due to local heat energy received from the laser, such that cracks may occur in the substrate.

The cracks that occur in a cut area of the substrate may extend to a surrounding area due to a stress that occurs as a subsequent process progresses.

For example, the cracks occurring in the cut area of the substrate may extend to an inner area of the display area. The cracks may propagate very easily through the light-emitting layer and the insulating layer disposed near the open area.

The cracks that occur in the cut area of the substrate in this open area may act as a moisture penetration path.

The light-emitting elements positioned in the display area and containing the organic material are particularly vulnerable to moisture. Thus, when the moisture penetrates the light-emitting element, this may lead to a defect in the light-emitting element.

In order to prevent the moisture infiltration due to the cracks occurring in this way, crack propagation prevention structures may be disposed between the display area and the open area to prevent the cracks occurring in the cut area of the open area from propagating.

For example, the light-emitting layer disposed on the crack propagation prevention structure is discontinuous or cuts off due to a step structure formed due to the crack propagation prevention structure. This may block the crack propagation path.

However, the step structure formed due to the crack propagation prevention structure may cause a seam-like defect in an inorganic insulating layer having a small thickness at a boundary portion between the crack propagation prevention structures.

When the seam-like defect occurs in the inorganic insulating layer, the inorganic insulating layer in an area where the seam occurs may not sufficiently cover an underlying structure and may become discontinuous or cut off.

The defect in the inorganic insulating layer that occurs in this way may act as an upper moisture permeation path.

When the precise cutting process using the laser is performed, static-electricity may be generated.

The static-electricity generated in this way may open an electrode in the display panel or short-circuit adjacent electrodes to each other, thereby damaging a circuit within the display panel.

Accordingly, through various experiments, the inventors of the present disclosure have invented a display device in which when an open area is defined within the display area, moisture infiltration is prevented, and a static-electricity discharge path is formed near the open area.

A purpose according to an embodiment of the present disclosure is to provide a display device which may prevent moisture penetration from a position on top of the insulating layer through the insulating layer near the open area within the display area.

Additionally, a purpose according to an embodiment of the present disclosure is to provide a display device that provides a robust structure against a crack that occurs near the open area within the display area.

Additionally, a purpose according to an embodiment of the present disclosure is to provide a display device that may prevent the crack from propagating through the insulating layer near the open area within the display area.

Additionally, a purpose according to an embodiment of the present disclosure is to provide a display device in which a path for discharging static-electricity to an outside is formed near the open area within the display area.

Additionally, a purpose according to an embodiment of the present disclosure is to provide a touch display device that may reduce occurrence of touch noise.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means shown in the claims or combinations thereof. According to an aspect of the present disclosure, a display device according to claim 1 is provided. Further embodiments are described in the dependent claims.

A display device according to an embodiment of the present disclosure includes a substrate including a display area, an open area positioned in the display area, and an intermediate area positioned between the display area and the open area; and a capping layer disposed on the intermediate area of the substrate and extending in a closed loop so as to surround the open area in a plan view of the device, wherein the capping layer includes a metal material, wherein the capping layer is connected to a ground or receives an electrical power having a constant voltage.

In addition, a display device according to an embodiment of the present disclosure includes a substrate including a display area, an open area positioned in the display area, and an intermediate area positioned between the display area and the open area; at least one disconnection area disposed on the intermediate area of the substrate; at least one insulating layer disposed to cover the at least one disconnection area; and a capping layer disposed in the intermediate area so as to cover the at least one disconnection area and to surround the open area in a plan view of the device, wherein the capping layer includes a metal material, wherein the capping layer is connected to a ground or receives an electrical power having a constant voltage.

According to an embodiment of the present disclosure, the capping layer surrounding the open area and including the metal material may be disposed on the intermediate area between the display area and the open area, thereby preventing moisture penetration from a position on top of the insulating layer through the insulating layer near the open area.

According to an embodiment of the present disclosure, the capping layer surrounding the open area and including the metal material may be disposed on the intermediate area between the display area and the open area. Thus, the capping layer may reduce the propagation of cracks through the insulating layer and thus provide a robust structure against cracks.

Further, according to an embodiment of the present disclosure, the capping layer surrounding the open area and including the metal material may be disposed on the intermediate area between the display area and the open area. The capping layer may be connected to the power connection line disposed thereunder via the power connection electrode, thereby cutting off the insulating layer. Thus, the propagation of cracks through the insulating layer may be prevented.

Further, according to an embodiment of the present disclosure, the capping layer surrounding the open area and including the metal material may be disposed on the intermediate area between the display area and the open area. The capping layer may be connected to the ground or may receive the power with a constant voltage. Thus, the static-electricity generated during the cutting process to form the open area may be discharged to the outside such that the occurrence of pixel defects may be reduced.

The occurrence of pixel defects may be reduced in this way, such that the lifespan of the display device may be improved. Further, power consumption may be reduced via implementation of a low-power display device.

Further, according to an embodiment of the present disclosure, the capping layer surrounding the open area and including the metal material may be disposed on the intermediate area between the display area and the open area. The capping layer may be connected to the ground or may receive the power with a constant voltage. Thus, the voltage of the capping layer may be kept constant without changing, thereby reducing occurrence of touch noise in the touch display device.

Effects of the present disclosure are not limited to the effects mentioned above, and other effects not mentioned will be clearly understood by those skilled in the art from the descriptions below.

### BRIEF DESCRIPTION OF DRAWINGS

FIG. 1 is a schematic plan view of a display device according to an embodiment of the present disclosure.
FIG. 2 is a schematic plan view of a display device including a static-electricity prevention wiring and a crack sensing wiring according to an embodiment of the present disclosure.
FIG. 3 is a cross-sectional view of one sub-pixel of a display device according to an embodiment of the present disclosure.
FIG. 4 is an enlarged plan view of an open area within a display area.
FIG. 5 is a cross-sectional view of an A-A' area of FIG. 4, and FIG. 6 and FIG. 7 are cross-sectional views of a B-B' area of FIG. 4.
FIG. 8, FIG. 9, and FIG. 10 are respectively a circuit diagram, a plan view, and a cross-sectional view near an open area of a display device according to an embodiment of the present disclosure.
FIG. 11, FIG. 12, and FIG. 13 are respectively a circuit diagram, a plan view, and a cross-sectional view near an open area of a display device according to another embodiment of the present disclosure.
FIG. 14, FIG. 15, and FIG. 16 are respectively a circuit diagram, a plan view, and a cross-sectional view near an open area of a display device according to still another embodiment of the present disclosure.

### DETAILED DESCRIPTIONS

Advantages and features of the present disclosure, and a method of achieving the advantages and features will become apparent with reference to embodiments described later in detail together with the accompanying drawings. However, the present disclosure is not limited to the embodiments as disclosed below, but may be implemented in various different forms. Thus, these embodiments are set forth only to make the present disclosure complete, and to completely inform the scope of the present disclosure to those of ordinary skill in the technical field to which the present disclosure belongs, and the present disclosure is only defined by the scope of the claims.

A shape, a size, a ratio, an angle, a number, etc. disclosed in the drawings for describing the embodiments of the present disclosure are exemplary, and embodiments of the present disclosure are not limited thereto. The same reference numerals refer to the same elements herein. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure. The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", " comprising", "include", and "including" when used in this specification, specify the presence of the stated features, integers, operations, elements, and/or components, but do not preclude the presence or addition of one or more other features, integers, operations, elements, components, and/or portions thereof.

In interpreting a numerical value, the value is interpreted as including an error range unless there is no separate explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when an element or layer is referred to as being "connected to", or "coupled to" another element or layer, it may be directly on, connected to, or coupled to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

In descriptions of temporal relationships, for example, temporal precedent relationships between two events such as "after", "subsequent to", "before", etc., another event may occur therebetween unless "directly after", "directly subsequent" or "directly before" is not indicated.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present disclosure.

The features of the various embodiments of the present disclosure may be partially or entirely combined with each other, and may be technically associated with each other or operate with each other. The embodiments may be implemented independently of each other and may be implemented together in an association relationship.

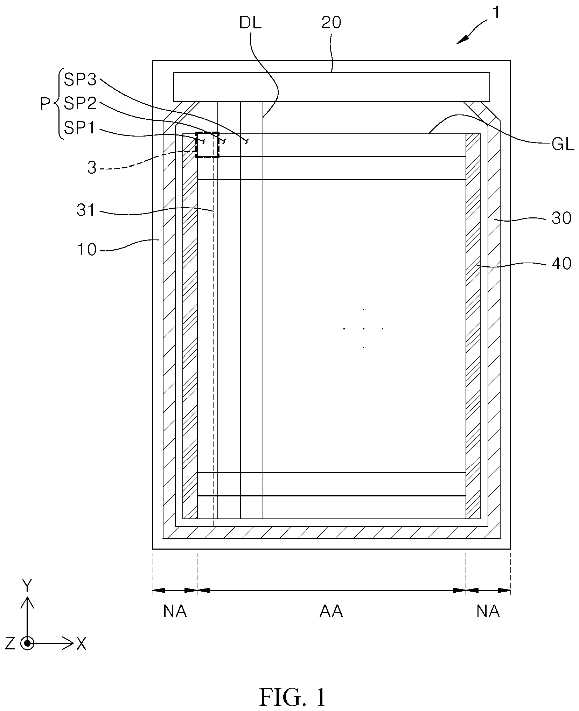

Hereinafter, a display device according to an embodiment of the present disclosure will be described in detail with reference to FIG. 1 to FIG. 3.

FIG. 1 is a schematic plan view of a display device according to an embodiment of the present disclosure.

Hereinafter, an example in which a display device 1 is embodied as an organic light-emitting diode display device is described. However, embodiments of the present disclosure are not limited thereto.

The display device 1 may include a substrate 10 including a display area AA and a non-display area NA surrounding the display area AA.

In the display area AA and on the substrate 10, a plurality of data lines DL extending in a first direction and a plurality of gate lines GL extending in a second direction intersecting the first direction may be disposed.

Each of sub-pixels SP1, SP2, and SP3 may be disposed in an area defined by the data line DL and the gate line GL intersecting each other.

The sub-pixels SP1, SP2, and SP3 may be implemented to emit light of the same color such as white (W) light. Alternatively, the sub-pixels SP1, SP2, and SP3 may be implemented to emit light of different colors such as red (R), green (G), and blue (B).

One pixel P may be composed of the plurality of sub-pixels SP1, SP2, and SP3 as described above.

The plurality of sub-pixels SP1, SP2, and SP3 may be arranged in a plurality of rows and columns and thus in a matrix format.

In the present disclosure, the first direction may be a column direction and may be defined as a Y-axis direction, while the second direction may be a row direction and may be defined as an X-axis direction.

A plurality of line and pads that supply various signals and power to the pixel may be disposed in the non-display area NA and on the substrate 10.

A data driver circuit (D-IC) 20 may be disposed in one side of the non-display area NA.

The data driver circuit 20 applies a data signal to the data line DL, and may apply driving voltages such as high potential voltage VDD and low potential voltage VSS to the pixel P.

A power line 30 may extend along an edge of the display area AA excluding one side of the non-display area NA where the data driver circuit 20 is disposed.

For example, a gate driver 40 that applies a gate signal to the gate line GL may be disposed in each of both opposing sides of the non-display area NA respectively positioned on both opposing sides of the display area AA. The power line 30 capable of applying voltage to an anode electrode or a cathode electrode within the pixel P may be disposed along and on an outer edge of the gate driver 40.

The gate driver 40 formed on the substrate 10 and in a gate-in-panel (GIP) scheme may be referred to as a GIP driver.

The power line 30 may include a low-potential voltage line capable of applying a low-potential voltage VSS to the cathode electrode of the pixel P. However, the present disclosure is not limited thereto, and the power line 30 may additionally include a high-potential voltage line capable of applying a high-potential voltage VDD to a thin-film transistor of the pixel P.

In the display area AA, a plurality of power connection lines 31 electrically connecting the power line 30 and the plurality of sub-pixels SP1, SP2, and SP3 to each other to apply a low potential voltage VSS to the plurality of sub-pixels SP1, SP2, and SP3 may be disposed.

For example, the plurality of power connection lines 31 may extend in the first direction in which the plurality of data lines DL extend.

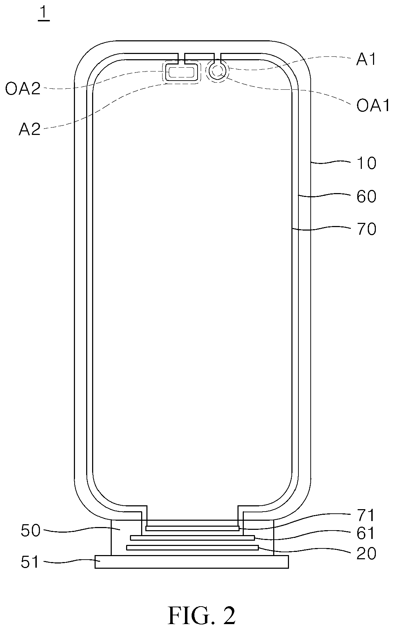

Referring to FIG. 2, one or more optical areas OA1 and OA2 may be formed within the display area AA.

For example, a first area A1 including the first optical area OA1 and a second area A2 including the second optical area OA2 may be formed within the display area AA.

The first optical area OA1 and the second optical area OA2 may be positioned in one side area of the display area AA in the column direction.

Each of the first optical area OA1 and the second optical area OA2 may be formed to have various shapes such as circular, oval, square, hexagon, or octagon.

A first optical electronic device may be disposed in the first optical area OA1, and a second optical electronic device may be disposed in the second optical area OA2.

In one example, the first optical electronic device may be a camera, and the second optical electronic device may be a detection sensor such as a proximity sensor, an illuminance sensor, or an infrared ray sensor.

The first optical area OA1 may be referred to as a camera hole, and the second optical area OA2 may be referred to as a sensor hole.

A flexible circuit board 50 and a printed circuit board 51 may be disposed in the other side area of the substrate 10 in the column direction.

One side of the flexible circuit board 50 may be connected to the substrate 10, and the other side of the flexible circuit board 50 may be connected to the printed circuit board 51.

The flexible circuit board 50 may be embodied as a chip on film (COF) or a flexible printed circuit board (FPC).

The data driver 20 that supplies a data signal for allowing the pixels to emit light may be disposed in the flexible circuit board 50.

The printed circuit board 51 may include various components that may supply various signals such as high-potential voltage, low-potential voltage, a scan signal, a data signal, or a touch detection signal to the data driver 20 and the gate driver 40.

A crack sensing wiring 60 may be disposed on the substrate 10.

The crack sensing wiring 60 may be formed to surround an outer edge of the display area AA of the substrate 10 and may extend along the non-display area NA.

The crack sensing wiring 60 extending on and along one side area in the column direction of the substrate 10 may extend on and along an area adjacent to the first optical area OA1 and the second optical area OA2, and may surround each of the first optical area OA1 and the second optical area OA2.

The first area A1 may be an area including the first optical area OA1 and the crack sensing wiring 60 surrounding an outer edge of the first optical area OA. The second area A2 may be an area including the second optical area OA2 and the crack sensing wiring 60 surrounding an outer edge of the second optical area OA2.

The crack sensing wiring 60 may be composed of a single line. However, the present disclosure is not limited thereto and the crack sensing wiring 60 may be composed of a plurality of lines.

A portion of the crack sensing wiring 60 extending on and along the other side area in the column direction of the substrate 10 may be connected to a crack sensing pad 61.

The crack sensing pad 61 may be disposed on the substrate 10. However, embodiments of the present disclosure are not limited thereto. The crack sensing pad 61 may be disposed on the flexible circuit board 50.

The crack sensing wiring 60 connected to the crack sensing pad 61 may be formed as a closed loop.

As previously described, the crack sensing wiring 60 may extend around the outer edge of each of the first optical area OA1 and the second optical area OA2. Thus, the crack sensing wiring 60 may be used to check whether cracks have occurred in each of the first optical area OA1 and the second optical area OA2.

A method of checking whether the crack has occurred through the crack sensing wiring 60 is as follows.

When performing a lighting test (Auto Probe: AP) for final inspection of the display panel of the display device 1, a certain level of power may be applied to the crack sensing pad 61 and input and output values thereto and therefrom may be compared to each other.

In this regard, a resistance caused by the crack sensing wiring 60 may be determined based on a difference between the output value and the input value. Thus, whether the crack sensing wiring 60 cuts off may be checked based on the resistance.

For example, when a crack occurs near the first optical area OA1, a portion or an entirety of the crack sensing wiring 60 may cut off.

When a portion of the crack sensing wiring 60 cuts off, the resistance may gradually increase and the output power may be weakened. When the crack sensing wiring 60 entirely cuts off, the output power may converge to 0. Thus, due to such resistance-related characteristics of the electricity, whether the cracks have occurred in the display panel may be checked.

The crack sensing pad 61 may be connected to a ground GND, and accordingly, the crack sensing wiring 60 connected to the crack sensing pad 61 and another line connected to the crack sensing wiring 60 may also be connected to the ground GND and thus may be grounded.

Additionally, a static-electricity prevention wiring 70 may be disposed on the substrate 10.

The static-electricity prevention wiring 70 may be referred to as a ESD (Electrostatic Discharge) wiring.

The static-electricity prevention wiring 70 may be formed to surround the outer edge of the display area AA of the substrate 10 and extend along the non-display area NA.

In one example, the static-electricity prevention wiring 70 may be positioned inwardly of the crack sensing wiring 60. However, embodiments of the present disclosure are not limited thereto.

The static-electricity prevention wiring 70 extending on and along one side area in the column direction of the substrate 10 may be formed to extend on and along an area adjacent to each of the first optical area OA1 and the second optical area OA2.

For example, the static-electricity prevention wiring 70 may be formed to extend along an area adjacent to one side in the column direction of each of the first optical area OA1 and the second optical area OA2. However, embodiments of the present disclosure are not limited thereto.

A portion of the static-electricity prevention wiring 70 extending on and along the other side area in the column direction of the substrate 10 may be connected to a static-electricity prevention pad 71.

The static-electricity prevention pad 71 may be disposed on the substrate 10. However, embodiments of the present disclosure are not limited thereto. The static-electricity prevention pad 71 may be disposed on the flexible circuit board 50.

The static-electricity prevention wiring 70 connected to the static-electricity prevention pad 71 may be formed as a closed loop.

The static-electricity prevention pad 71 may be connected to a ground GND. Thus, the static-electricity prevention wiring 70 connected to the static-electricity prevention pad 71, and another line connected to the static-electricity prevention wiring 70 may also be connected to the ground GND and thus may be grounded.

Therefore, the static-electricity prevention wiring 70 may play the role of discharging static-electricity generated from the display panel to an outside out of the display panel.

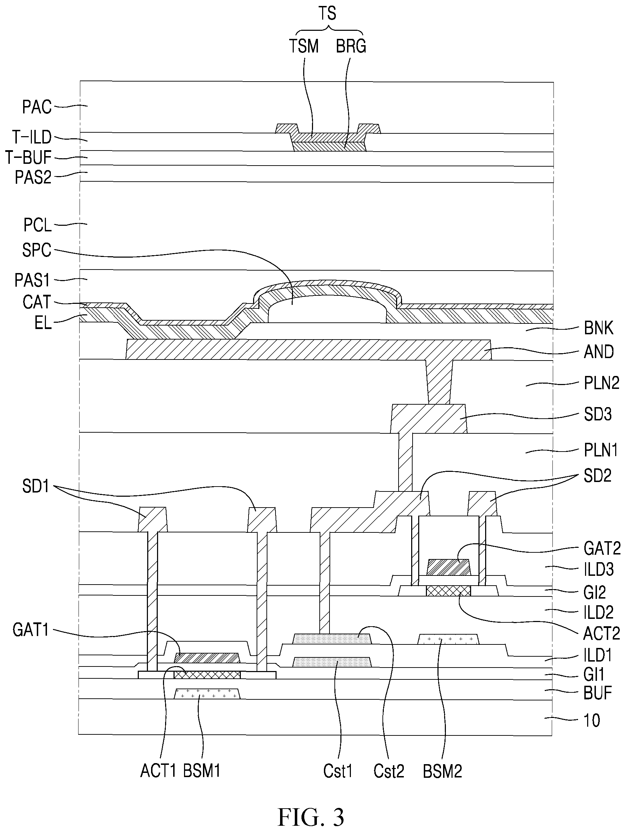

Referring to FIG. 3, the sub-pixel within the display area AA according to an embodiment of the present disclosure will be described in detail.

The substrate 10 may be made of glass or plastic such as polyimide.

A first thin-film transistor, a storage capacitor, and a second thin-film transistor may be disposed on the substrate 10.

A first light blocking layer BSM1 may be disposed on the substrate 10.

The first light blocking layer BSM1 may protect a first active layer ACT1 of the first thin-film transistor by blocking light incident from the outside.

Accordingly, the first light blocking layer BSM1 may overlap the first active layer ACT1 of the first thin-film transistor in a vertical direction.

The vertical direction in FIG. 3 may mean a Z-axis direction.

A buffer layer BUF may be disposed on the first light blocking layer BSM1.

The buffer layer BUF may be composed of a single or a double layer embodied as an inorganic insulating layer. However, embodiments of the present disclosure are not limited thereto.

For example, the inorganic insulating layer as described in the present disclosure may include silicon oxide (SiOₓ) or silicon nitride (SiNₓ).

The buffer layer BUF may be referred to as a lower buffer layer.

The first active layer ACT1 may be disposed on the buffer layer BUF.

The first active layer ACT1 may be made of an oxide semiconductor material. However, embodiments of the present disclosure are not limited thereto.

A first gate insulating layer GI1 may be disposed on the first active layer ACT1.

The first gate insulating layer GI1 may be composed of a single or a double layer embodied as an inorganic insulating layer. However, embodiments of the present disclosure are not limited thereto.

A first gate electrode GAT1 may be disposed on the first gate insulating layer GI1.

The first gate electrode GAT1 may be disposed to overlap the first active layer ACT1 in the vertical direction.

Additionally, a first capacitor electrode Cst1 may be disposed on the first gate insulating layer GI1.

The first gate electrode GAT1 and the first capacitor electrode Cst1 may be formed in the same layer and made of the same material.

A first interlayer insulating layer ILD1 may be disposed on the first gate electrode GAT1 and the first capacitor electrode Cst1.

The first interlayer insulating layer ILD1 may be composed of a single layer or a double layer embodied as an inorganic insulating layer. However, embodiments of the present disclosure are not limited thereto.

A second capacitor electrode Cst2 may be disposed on the first interlayer insulating layer ILD1.

The second capacitor electrode Cst2 may be disposed to overlap the first capacitor electrode Cst1 in the vertical direction. The storage capacitor may be composed of the second capacitor electrode Cst2 and the first capacitor electrode Cst1.

Additionally, a second light blocking layer BSM2 may be disposed on the first interlayer insulating layer ILD1.

The second light blocking layer BSM2 may protect a second active layer ACT2 of the second thin-film transistor by blocking light incident from the outside.

Accordingly, the second light blocking layer BSM2 may be disposed to overlap the second active layer ACT2 of the second thin-film transistor in the vertical direction.

A second interlayer insulating layer ILD2 may be disposed on the second capacitor electrode Cst2 and the second light blocking layer BSM2.

The second active layer ACT2 may be disposed on the second interlayer insulating layer ILD2.

The second active layer ACT2 may be made of an oxide semiconductor material. However, embodiments of the present disclosure are not limited thereto.

A second gate insulating layer GI2 may be disposed on the second active layer ACT2.

The second gate insulating layer GI2 may be composed of a single or double layer embodied as an inorganic insulating layer. However, embodiments of the present disclosure are not limited thereto.

A second gate electrode GAT2 may be disposed on the second gate insulating layer GI2.

The second gate electrode GAT2 may be disposed to overlap the second active layer ACT2 in the vertical direction.

A third interlayer insulating layer ILD3 may be disposed on the second gate electrode GAT2.

The third interlayer insulating layer ILD3 may be composed of a single or double layer embodied as an inorganic insulating layer. However, embodiments of the present disclosure are not limited thereto.

The third interlayer insulating layer ILD3 may be referred to as an upper buffer layer.

A pair of first source/drain electrodes SD1 and a pair of second source/drain electrodes SD2 may be disposed on the third interlayer insulating layer ILD3.

The pair of first source/drain electrodes SD1 may be connected to one side and the other side of the first active layer ACT1, respectively via contact holes extending through the third interlayer insulating layer ILD3, the second gate insulating layer GI2, the second interlayer insulating layer ILD2, the first interlayer insulating layer ILD1, and the first gate insulating layer GI1.

The first thin-film transistor may be composed of the first active layer ACT1, the first gate electrode GAT1, and the pair of first source/drain electrodes SD1 formed in this way.

The pair of second source/drain electrodes SD2 may be connected to one side and the other side of the second active layer ACT2, respectively, via contact holes extending through the third interlayer insulating layer ILD3 and the second gate insulating layer GI2.

The second thin-film transistor may be composed of the second active layer ACT2, the second gate electrode GAT2, and the pair of second source/drain electrodes SD2 formed in this way.

One of the second source/drain electrodes SD2 may be electrically connected to the second capacitor electrode Cst2.

For example, one of the second source/drain electrodes SD2 may be electrically connected to the second capacitor electrode Cst2 via a contact hole extending through the third interlayer insulating layer II,D3, the second gate insulating layer GI2, and the second interlayer insulating layer II,D2.

A first planarization layer PLN1 may be disposed on the pair of first source/drain electrodes SD1 and the pair of second source/drain electrodes SD2.

The first planarization layer PLN1 may play a role in planarizing a step formed by an underlying circuit element including the thin-film transistors.

The first planarization layer PLN1 may include an organic insulating material such as acryl resin, epoxy resin, phenolic resin, polyamide resin, or polyimide resin. However, embodiments of the present disclosure are not limited thereto.

A third source/drain electrode SD3 may be disposed on the first planarization layer PLN1.

The third source/drain electrode SD3 may function as a connection electrode connecting the second source/drain electrode SD2 and the anode electrode AND to each other.

The third source/drain electrode SD3 may be connected to the second source/drain electrode SD2 via a contact hole extending through the first planarization layer PLN1.

A second planarization layer PLN2 may be disposed on the third source/drain electrode SD3.

The second planarization layer PLN2 may include an organic insulating material such as acryl resin, epoxy resin, phenolic resin, polyamide resin, or polyimide resin. However, embodiments of the present disclosure are not limited thereto.

The anode electrode AND may be disposed on the second planarization layer PLN2.

The anode electrode AND may be connected to the third source/drain electrode SD3 via a contact hole extending through the second planarization layer PLN2.

A bank BNK may be disposed on the anode electrode AND.

The bank BNK may be formed to cover an edge portion of the anode electrode AND.

The bank BNK serves to distinguish the sub-pixels SP1, SP2, and SP3 from each other and prevents light beams of different colors output from adjacent ones of the sub-pixels SP1, SP3, and SP3 from being mixed with each other.

The bank BNK may include an organic insulating material such as acryl resin, epoxy resin, phenolic resin, polyamide resin, or polyimide resin. However, embodiments of the present disclosure are not limited thereto.

A light-emitting layer EL may be disposed on the anode electrode AND.

The light-emitting layer EL may include an organic material that emits light. The light-emitting layers EL of the sub-pixels SP1, SP2, and SP3 may emit light of different colors.

For example, the light-emitting layer EL may emit light of one color of red, green, blue, and white.

In addition, the light-emitting layer EL may be made of an organic material that emits white light. In this case, color filters rendering different colors may be additionally disposed on top of the light-emitting layer EL, thereby emitting light of red, green, and blue colors.

The light-emitting layer EL may be embodied as an organic light-emitting layer having a stack structure in which a hole transport layer, a light-emitting material layer, an electron transport layer, a hole blocking layer, a hole injection layer, an electron blocking layer, and an electron injection layer are stacked.

The light-emitting layer EL may be formed to cover the anode electrode AND and a side surface and a portion of an upper surface of the bank BNK.

Alternatively, the light-emitting layer EL may be formed over an entirety of the display area AA to cover the anode electrode AND and an exposed surface of the bank BNK.

The light-emitting layer EL may be formed to extend across the display area AA and extend to a boundary of the open area OA.

A spacer SPC may be disposed between the bank BNK and the light-emitting layer EL.

The spacer SPC may include the same material as that of the bank BNK.

The spacer SPC protects the light-emitting layer EL from external shock. Furthermore, during a process of depositing the light-emitting layer EL, the spacer SPC may provide a space to prevent the substrate 10 from being in direct contact with a deposition screen mask.

The cathode electrode CAT may be disposed on the light-emitting layer EL.

The cathode electrode CAT may be formed to cover the light-emitting layer EL.

The cathode electrode CAT may be formed to extend to cover the plurality of pixels P.

An area where the anode electrode AND, the light-emitting layer EL, and the cathode electrode CAT formed in this way overlap each other may function as an organic electroluminescent element or an organic light-emitting diode element (OLED).

FIG. 3 shows that the anode electrode AND is positioned under the light-emitting layer EL and the cathode electrode CAT is positioned on top of the light-emitting layer EL. However, embodiments of the present disclosure are not limited thereto. The cathode electrode CAT may be positioned under the light-emitting layer EL, while the anode electrode AND may be positioned on top of the light-emitting layer EL.

A first passivation layer PAS 1 may be disposed on the cathode electrode CAT.

The first passivation layer PAS1 may be composed of a single or double layer embodied as an inorganic insulating layer. However, embodiments of the present disclosure are not limited thereto.

The first passivation layer PAS1 may serve to protect the light-emitting element from external oxygen or moisture.

An encapsulation layer PCL may be formed on the first passivation layer PAS 1.

The encapsulation layer PCL may have a sufficient thickness to cover the first passivation layer PAS1 and to have a flat top surface.

The encapsulation layer PCL may prevent foreign materials from invading into the light-emitting element.

The encapsulation layer PCL may include an organic insulating material.

For example, the encapsulation layer PCL may include an organic insulating material such as acryl resin, epoxy resin, phenolic resin, polyamide resin, or polyimide resin. However, embodiments of the present disclosure are not limited thereto.

A second passivation layer PAS2 may be disposed on the encapsulation layer PCL.

The second passivation layer PAS2 may be composed of a single or double layer embodied as an inorganic insulating layer. However, embodiments of the present disclosure are not limited thereto.

The second passivation layer PAS2 may serve to protect the light-emitting element from external oxygen or moisture.

A combination of the first passivation layer PAS 1, the encapsulation layer PCL, and the second passivation layer PAS2 may constitute an encapsulation layer in a broad sense.

A touch panel may be additionally disposed on the display panel described as above.

For example, a touch buffer layer T-BUF may be disposed on the second passivation layer PAS2.

For example, the touch buffer layer T-BUF may be composed of a single or double layer embodied as an inorganic insulating layer. However, embodiments of the present disclosure are not limited thereto.

A touch sensor TS may be disposed on the touch buffer layer T-BUF.

The touch sensor TS may include a touch sensor metal TSM and a bridge metal BRG positioned in different layers.

The touch sensor TS may be referred to as a touch electrode layer TS, and the touch sensor metal TSM and the bridge metal BRG may be referred to as a second touch electrode TSM and a first touch electrode BRG, respectively.

A touch interlayer insulating layer T-ILD may be disposed between the touch sensor metal TSM and the bridge metal BRG.

For example, the touch sensor metal TSM may include a pair of first touch sensor metals TSM1 and a pair of second touch sensor metals TSM2 disposed adjacent to each other.

The second touch sensor metal TSM2 may be disposed between the pair of first touch sensor metals TSM1. In this case, the pair of first touch sensor metals TSM1 may be electrically connected to each other via the bridge metal BRG positioned in a layer different from a layer of the pair of first touch sensor metals TSM1.

The bridge metal BRG may be insulated from the second touch sensor metal TSM2 via the touch interlayer insulating layer T-II,D.

A protective layer PAC may be disposed on the touch sensor TS.

The protective layer PAC may include an organic insulating material such as acryl resin, epoxy resin, phenolic resin, polyamide resin, or polyimide resin. However, embodiments of the present disclosure are not limited thereto.

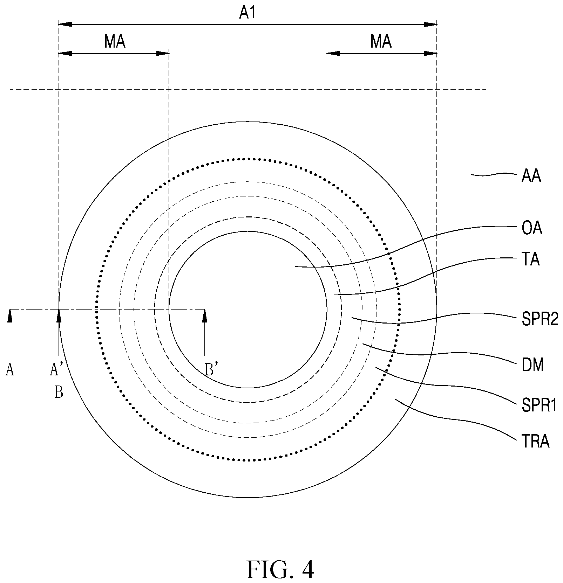

Hereinafter, the first area A1 will be described in more detail with reference to FIGS. 4 to 7.

The second area A2 may have substantially the same structure as that of the first area A1, and thus a detailed description thereof will be omitted.

The first area A1 may include an open area OA where a hole is formed by cutting a portion of the display area AA.

An intermediate area MA may be formed around the open area OA.

The intermediate area MA may be an inner bezel area where the sub-pixels SP1, SP2, and SP3 are not disposed.

Therefore, each of the open area OA and the intermediate area MA may be a non-active area positioned in the display area AA.

An area outside the intermediate area MA may be the display area AA where the sub-pixels SP1, SP2, and SP3 are disposed.

The intermediate area MA may prevent moisture penetration that may occur along a trimming line of the open area OA, and may prevent fine cracks that may occur in a process of forming the open area OA from propagating into the display area AA.

The intermediate area MA may include a trimming margin area TA, a second disconnection area SPR2, a dam area DM, a first disconnection area SPR1, and a touch routing area TRA sequentially arranged in a direction from the open area OA to the display area AA.

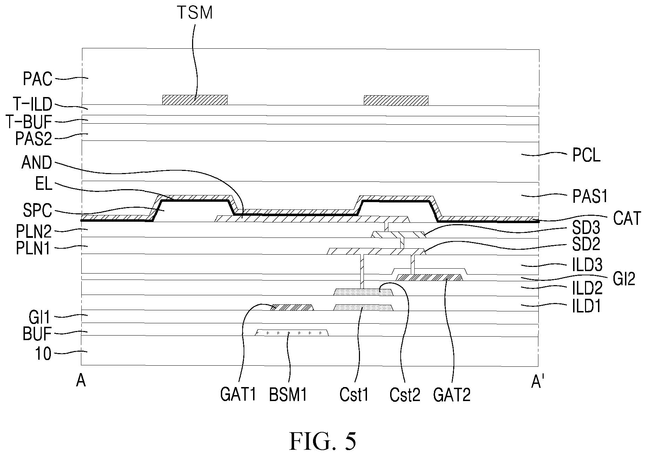

FIG. 5 is a cross-sectional view of the display area AA as shown along an A-A' line in FIG. 4. Descriptions that duplicate with the descriptions about the display area AA as previously described with reference to FIG. 3 are omitted.

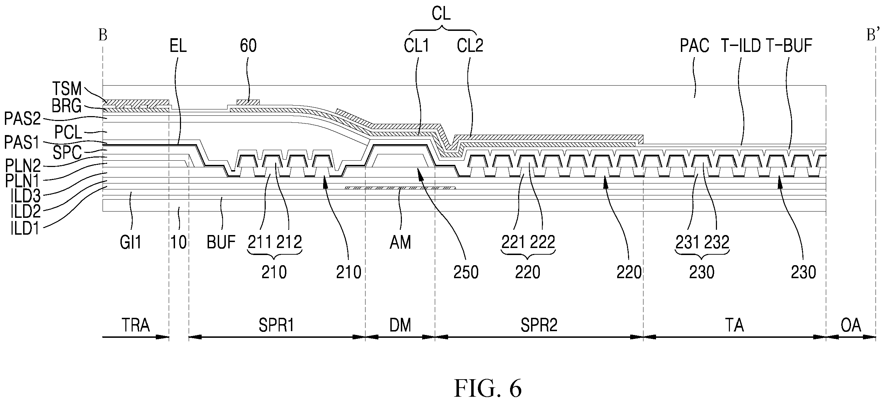

FIG. 6 is a cross-sectional view of the first area A1 as shown along a B-B' line in FIG. 4.

The touch sensor including the touch sensor metal TSM and the bridge metal BRG positioned in the different layers may be disposed in the touch routing area TRA.

One or more first disconnection structures 210 may be disposed in the first disconnection area SPR1.

The first disconnection structures 210 adjacent to each other may be spaced apart from each other.

The first disconnection structures 210 may be formed in a concavo-convex pattern.

For example, the first disconnection structure 210 may be formed by removing at least a portion of the organic insulating layer such as the first planarization layer PLN1 and the second planarization layer PLN2.

The first disconnection structure 210 may be formed to have a two-layer structure.

In one example, the first disconnection structure 210 may include a first lower structure 211 and a first upper structure 222 disposed on top of the first lower structure 211. The first lower structure 211 may have a taper shape in which a width decreases as it extends upwardly. The first upper structure 222 may have a taper shape in which a width decreases as it extends upwardly.

The first lower structure 211 may be made of the same material as that of the third interlayer insulating layer II,D3, and the first upper structure 212 may be made of the same material as that of the second planarization layer PLN2. However, embodiments of the present disclosure are not limited thereto.

Accordingly, the first disconnection structure 210 may define an undercut structure under the first upper structure 212 and adjacent to the first lower structure 211.

Due to a shape of the first disconnection structure 210 formed in this way, the light-emitting layer EL disposed on the first disconnection structure 210 may extend discontinuously. For example, the light-emitting layer EL may have a stack structure including a hole transport layer, an electron transport layer, a hole blocking layer, a hole injection layer, an electron blocking layer, and an electron injection layer. However, embodiments of the present disclosure are not limited thereto.

That is, the light-emitting layer EL extending between the adjacent first disconnection structures 210 may extend discontinuously because the light-emitting layer EL cuts off due to the undercut structure defined by the first disconnection structures 210.

As the light-emitting layer EL positioned in the intermediate area MA extends discontinuously, the intermediate area MA may effectively block the moisture flowing through a portion of the light-emitting layer EL in the intermediate area MA from the open area OA.

Since the first disconnection structure 210 performs the function of cutting off the light-emitting layer EL, the first disconnection structure 210 may be referred to as a cutter.

One or more dams 250 may be disposed in the dam area DM.

The dam 250 may serve to prevent the encapsulation layer PCL from overflowing to an outside out of the dam 250.

For example, the dam 250 may be formed by patterning the third interlayer insulating layer ILD3, the second planarization layer PLN2, and the spacer SPC.

An align metal layer AM at the same layer as the first gate electrode GAT1 may be formed under the dam 250. When the display area is partially cut by irradiating the laser thereto to form the open area OA therein, the align metal layer AM may serve as a mark so that the laser may be accurately irradiated to an area corresponding to the open area OA without an error. One or more second disconnection structures 220 may be disposed in the second disconnection area SPR2.

The second disconnection structures 220 adjacent to each other may be disposed to be spaced apart from each other.

The second disconnection structure 220 may be formed as a two-layer structure including a second lower structure 221 as a lower portion thereof and a second upper structure 222 as an upper portion thereof.

The second disconnection structure 220 is formed to have the same shape as that of the first disconnection structure 210. Thus, an undercut structure is defined under the second upper structure 222 and adjacent to the second lower structure 221.

Due to the shape of the second disconnection structure 220 formed in this way, the light-emitting layer EL disposed on the second disconnection structure 220 may discontinuously extend.

Additionally, one or more third disconnection structures 230 may be disposed in the trimming margin area TA.

The third disconnection structures 230 adjacent to each other may be disposed to be spaced apart from each other.

The third disconnection structure 230 may be formed as a two-layer structure composed of a third lower structure 231 as a lower portion thereof and a third upper structure 232 as an upper portion thereof.

The third disconnection structure 230 is formed to have the same shape as that of the second disconnection structure 220. Thus, an undercut structure may be defined under the third upper structure 232 and adjacent to the third lower structure 231.

Due to the shape of the third disconnection structure 230 formed in this way, the light-emitting layer EL disposed on the third disconnection structure 230 may discontinuously extend.

As the light-emitting layer EL positioned in the intermediate area MA extends discontinuously, the intermediate area MA may effectively block the moisture flowing through a portion of the light-emitting layer EL in the intermediate area MA from the open area OA.

An area inwardly of the trimming margin area TA may be the open area OA.

The trimming margin area TA may be formed to have a predetermined width in consideration of a process error that may occur when partially cutting the display area by irradiating the laser thereto to form the open area OA.

The trimming margin area TA may be formed to have substantially the same layer structure as that of the second disconnection area SPR2.

Therefore, in a broad sense, the trimming margin area TA may be referred to as being included in the second disconnection area SPR2.

The first passivation layer PAS1 may be disposed on the first disconnection structure 210, the second disconnection structure 220, the third disconnection structure 230, and the dam 250 formed in this way.

The first passivation layer PAS 1 may be formed to fill a space between the adjacent ones of the disconnection structures 210, 220, and 230.

However, due to the undercut structure defined by each of the disconnection structures 210, 220, and 230, the first passivation layer PAS 1 as the inorganic insulating layer having a relatively smaller thickness that that of the organic insulating layer may cut off in the space between adjacent ones of the disconnection structures 210, 220, and 230. Thus, a defect such as a seam may occur in the space.

In this way, the first passivation layer PAS 1 does not continuously cover the underlying structures and extends discontinuously in the intermediate area MA. Thus, an area where the seam occurs may act as a moisture permeation path in which moisture flows from a top downwardly.

The encapsulation layer PCL as the organic insulating layer may be disposed on a portion of the first passivation layer PAS 1 in the first disconnection area SPR1 positioned outwardly of the dam 250.

A separate organic insulating layer may not be positioned in the second disconnection area SPR2 and the trimming margin area TA positioned inwardly of the dam 250.

On the first passivation layer PAS1, the inorganic insulating layers such as the second passivation layer PAS2, the touch buffer layer T-BUF, and the touch interlayer insulating layer T-II,D may be additionally disposed.

Since the encapsulation layer PCL may be additionally disposed on the first passivation layer PAS 1 in the first disconnection area SPR1, the moisture permeability path through the seam formed in the first passivation layer PAS 1 may be blocked. However, in the second disconnection area SPR2 and the trimming margin area TA in which the thin inorganic insulating layers are stacked, a scheme of blocking the moisture permeation path through the seam formed in the first passivation layer PAS 1 is required.

Accordingly, the display device 1 according to an embodiment of the present disclosure may include a capping layer CL in the intermediate area MA.

The capping layer CL may include a first capping layer CL1 disposed on the touch buffer layer T-BUF and a second capping layer CL2 disposed on the touch interlayer insulating layer T-ILD.

Accordingly, the capping layer CL may be formed in a dual structure in which a first capping layer CL1 as a lower layer and a second capping layer CL2 as an upper layer are stacked.

The first capping layer CL1 may be disposed in the same layer as a layer of the first touch electrode BRG and may be made of the same material as that of the first touch electrode BRG.

Additionally, the second capping layer CL2 may be disposed in the same layer as a layer of the second touch electrode TSM and may be made of the same material as a material of the second touch electrode TSM.

Each of the first capping layer CL1 and the second capping layer CL2 may include a metal material.

For example, each of the first capping layer CL1 and the second capping layer CL2 may be embodied as a single layer or a multilayer made of one of molybdenum (Mo), aluminum (Al), chromium (Cr), gold (Au), titanium (Ti), nickel (Ni), neodymium (Nd), and copper (Cu) or an alloy thereof. However, embodiments of the present disclosure are not limited thereto.

The first capping layer CL1 and the second capping layer CL2 may be disposed so as not to be electrically connected to each other while the touch interlayer insulating layer T-ILD is interposed therebetween. However, embodiments of the present disclosure are not limited thereto. In alternative embodiments, the first capping layer CL1 and the second capping layer CL2 may be electrically connected to each other via a contact hole extending through the touch interlayer insulating layer T-ILD.

The first capping layer CL1 and the second capping layer CL2 may be disposed to overlap each other in the vertical direction.

The second capping layer CL2 may be formed to have a larger area size than that of the first capping layer CL1.

Each of the first capping layer CL1 and the second capping layer CL2 may be disposed to surround the open area OA and may be formed in a form of a closed loop.

The capping layer CL may be disposed in a least a portion of the intermediate area MA.

In one embodiment, referring to FIG. 6, the capping layer CL may be disposed on the first disconnection area SPR1, the dam area DM, and the second disconnection area SPR2.

In this case, the capping layer CL may be disposed to entirely cover the dam area DM and the second disconnection area SPR2. The capping layer CL may be disposed to covers only a portion of the first disconnection area SPR1 adjacent to the dam area DM.

Additionally, in the first disconnection area SPR1, the second capping layer CL2 may be disposed to have an area size smaller than that of the first capping layer CL1.

For example, the first capping layer CL1 may be formed to extend further toward the display area AA beyond the second capping layer CL2.

On a portion of the first capping layer CL1 extending further beyond the second capping layer CL2, the crack sensing wiring 60 may be disposed to overlap the portion in the vertical direction.

The crack sensing wiring 60 may be disposed in the same layer as a layer of the second capping layer CL2 and may be made of the same material.

The crack sensing wiring 60 may be disposed to overlap the first disconnection structure 210 in the vertical direction.

The crack sensing wiring 60 may be disposed to surround the open area OA.

For example, the crack sensing wiring 60 may be disposed to partially surround the open area OA in a manner such that a portion of the open area OA is not blocked by the crack sensing wiring 60 so as to be exposed.

According to an embodiment of the present disclosure as described above, the capping layer CL may be disposed in the intermediate area MA between the display area AA and the open area OA so as to surround the open area OA, thereby blocking the moisture penetration from a position on top of the insulating layer therethrough near the open area OA.

In this case, the capping layer CL may be formed to surround the open area OA in a form of a closed loop, and thus may block the moisture permeation path more effectively.

In addition, the capping layer CL of the double layer structure embodied as the first capping layer CL1 and the second capping layer CL2 may be disposed to cover the second disconnection area SPR2. Thus, an upper moisture permeation path in the second disconnection area SPR2 in which the inorganic insulating layers are stacked may be blocked more effectively.

In addition, the capping layer CL disposed on top of the insulating layer includes a metal material. Thus, the propagation of cracks through the insulating layer may be reduced, thereby providing a strong structure against cracks.

In this case, the capping layer CL may be formed to surround the open area OA in the closed loop, so that the crack propagation path may be blocked more effectively.

Referring to FIG. 6, one end of the capping layer CL of the display device 1 according to an embodiment of the present disclosure may be positioned at a boundary between the second disconnection area SPR2 and the trimming margin area TA.

Therefore, the capping layer CL may be disposed so as not to overlap the trimming margin area TA in the vertical direction, and may be spaced, by a predetermined distance, from the open area OA.

The second capping layer CL2 may further extend beyond one end of the first capping layer CL1 facing the open area OA toward the open area OA so as to cover the one end of the first capping layer CL1.

For example, one end of the second capping layer CL2 may be positioned at a boundary between the second disconnection area SPR2 and the trimming margin area TA, while one end of the first capping layer CL1 may be positioned inwardly of the boundary.

The capping layer CL is not disposed in the trimming margin area TA. Thus, when the laser cutting process is performed to form the open area OA, there is no need to additionally consider or change a process condition of the laser cutting process to additionally cut the capping layer CL. This may be advantageous in terms of the process.

Additionally, as the second capping layer CL2 extends further toward the open area OA beyond the first capping layer CL1, the second capping layer CL2 may be disposed to cover a side surface of the touch interlayer insulating layer T-ILD positioned on one end of the first capping layer CL1.

Accordingly, the side surface of the touch interlayer insulating layer T-ELD may be screened with the second capping layer CL2 so as not to be exposed to the outside. Thus, a moisture penetration path and a crack propagation path that may occur through the touch interlayer insulating layer T-ILD may be blocked more effectively.

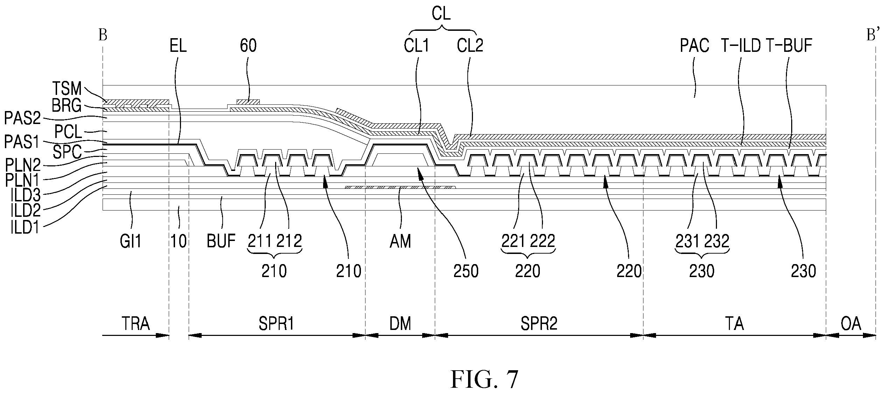

Referring to FIG. 7, one end of the capping layer CL of the display device 1 according to another embodiment of the present disclosure may be positioned at the boundary between the trimming margin area TA and the open area OA.

In this case, one end of the first capping layer CL1 and one end of the second capping layer CL2 may be positioned at the boundary between the trimming margin area TA and the open area OA. That is, one end of the first capping layer CL1 and one end of the second capping layer CL2 may be aligned with each other in the vertical direction.

This structure may be achieved by cutting the trimming margin area TA including the capping layer CL such that one end of the capping layer CL is positioned at the boundary between the trimming margin area TA and the open area OA when the laser cutting process is performed to form the open area OA.

In this way, the capping layer CL may extend further into the trimming margin area TA, and the boundary between the open area OA and the trimming margin area TA may coincide with one end of the capping layer CL. Thus, the capping layer CL may extend from a point at which the moisture permeation path and the crack propagation path start to extend, thereby not only blocking the moisture infiltration path from a position above the insulating layer therethrough more effectively, but also providing a strong structure against the cracks.

When the precise cutting process using the laser is performed to form the open area OA, the static-electricity may be generated. For this reason, a structure that may discharge the static-electricity to the outside is needed.

Further, when the capping layer CL containing a metal material is disposed in a floating manner, a voltage of the capping layer CL may fluctuate such that touch noise may occur. Thus, a structure that may resolve this touch noise is needed.

Accordingly, according to an embodiment of the present disclosure, the capping layer CL extending to surround the open area OA may be connected to the ground or a power with a constant voltage may be applied to the capping layer CL so that the capping layer CL may have the constant voltage.

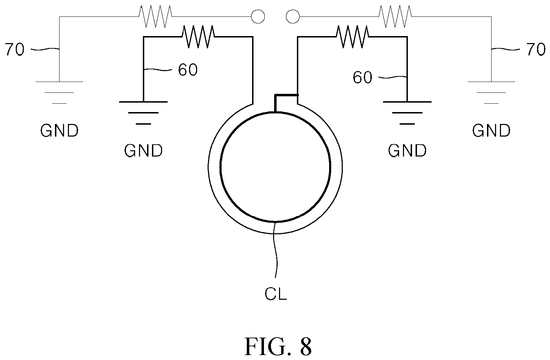

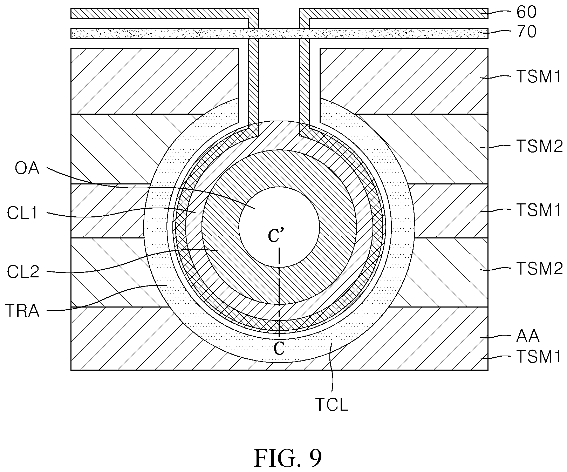

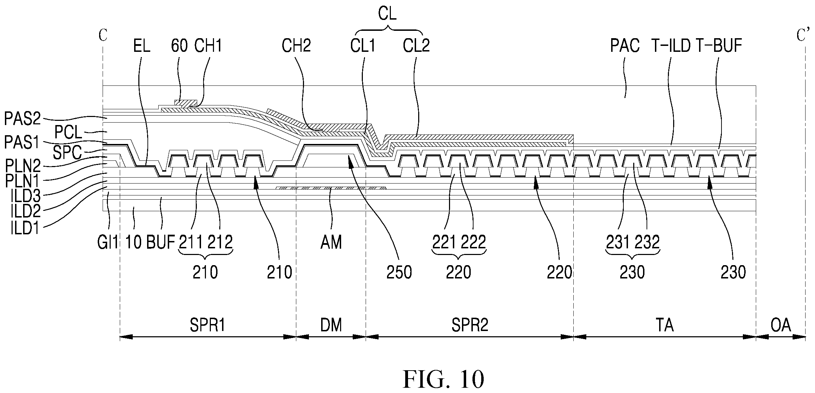

An embodiment of the present disclosure will be described with reference to FIGS. 8 to 10. The capping layer CL may be electrically connected to the crack sensing wiring 60.

Since the crack sensing wiring 60 is connected to the ground GND, the capping layer CL may be connected to the ground GND via the crack sensing wiring 60 and thus may be grounded.

For example, the crack sensing wiring 60 positioned in the first disconnection area SPR1 may be electrically connected to the first capping layer CL1 via a first contact hole CH1 extending through the touch interlayer insulating layer T-ILD.

The first contact hole CH1 may be formed so as to overlap the encapsulation layer PCL positioned thereunder in the vertical direction. Thus, the first contact hole may be formed stably in a planarized area through the organic insulating layer.

Additionally, the first capping layer CL1 may be electrically connected to the second capping layer CL2 via a second contact hole CH2 extending through the touch interlayer insulating layer T-ILD.

The second contact hole CH2 may be formed so as to overlap the dam 250 positioned thereunder in the vertical direction. Thus, the second contact hole may be formed stably in a planarized area through the organic insulating layer.

The crack sensing wiring 60 may be disposed outwardly of the static-electricity prevention wiring 70.

The touch sensor metal TSM may be disposed around the first capping layer CL1 so as to surround the first capping layer CL1.

For example, the touch sensor metal TSM may include the first touch sensor metal TSM1 and the second touch sensor metal TSM2.

The first touch sensor metals TSM1 and the second touch sensor metals TSM2 may be arranged alternately with each other.

In this case, the first touch sensor metals TSM1 adjacent to each other may be electrically connected to each other via the bridge metal BRG disposed thereunder.

Additionally, the touch sensor metal TSM may additionally include a touch connection portion TCL.

The touch connection portion TCL may be disposed closer to the first capping layer CL1 than each of the first touch sensor metal TSM1 and the second touch sensor metal TSM2 may be. The touch connection portion TCL may be spaced, by a predetermined distance, from the first capping layer CL1. The touch connection portion TCL may surround the first capping layer CL1.

The first touch sensor metal TSM1 and the second touch sensor metal TSM2 may be electrically connected to each other via the touch connection portion TCL.

The first touch sensor metal TSM1, the second touch sensor metal TSM2, and the touch connection portion TCL may be made of the same material and may be disposed in the same layer.

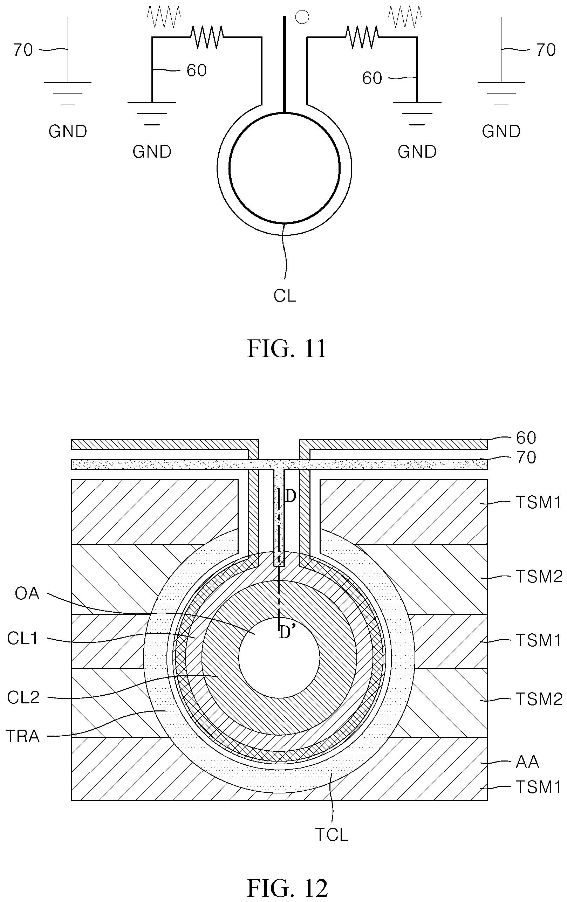

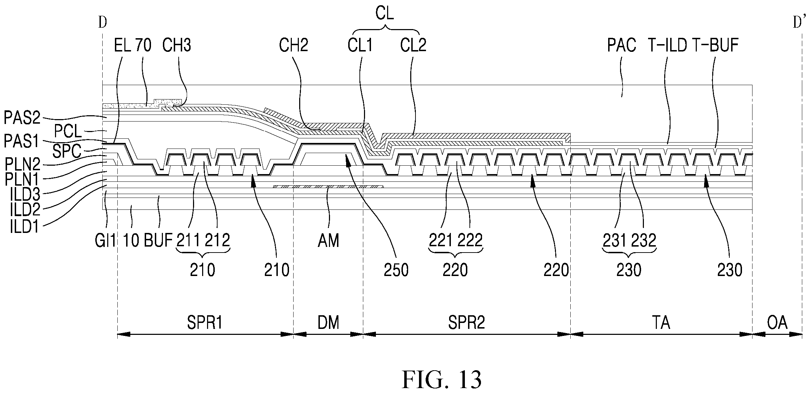

Another embodiment of the present disclosure will be described with reference to FIGS. 11 to 13. The capping layer CL may be electrically connected to the static-electricity prevention wiring 70.

Since the static-electricity prevention wiring 70 is connected to the ground GND, the capping layer CL may be connected to the ground GND via the static-electricity prevention wiring 70 and thus may be grounded.

For example, the static-electricity prevention wiring 70 extending into the first disconnection area SPR1 may be electrically connected to the first capping layer CL 1 via a third contact hole CH3 extending through the touch interlayer insulating layer T-ILD.

The third contact hole CH3 may be formed so as to overlap with the encapsulation layer PCL positioned thereunder in the vertical direction, and thus, may be formed stably in a planarized area through the organic insulating layer.

Additionally, the first capping layer CL1 may be electrically connected to the second capping layer CL2 via the second contact hole CH2 extending through the touch interlayer insulating layer T-ILD.

The second contact hole CH2 may be formed so as to overlap with the dam 250 positioned thereunder in the vertical direction and thus, may be formed stably in a planarized area through the organic insulating layer.

Accordingly, according to an embodiment of the present disclosure, the capping layer CL extending to surround the open area OA may be connected to the ground GND. Thus, the static-electricity generated during the cutting process to form the open area OA may be discharged to the outside such that occurrence of pixel defects may be reduced.

Further, according to an embodiment of the present disclosure, the capping layer CL extending to surround the open area OA may be connected to the ground GND, such that the voltage of the capping layer CL may be kept constant without changing, thereby reducing occurrence of touch noise in a touch display device.

The crack sensing wiring 60 may be disposed outwardly of the static-electricity prevention wiring 70.

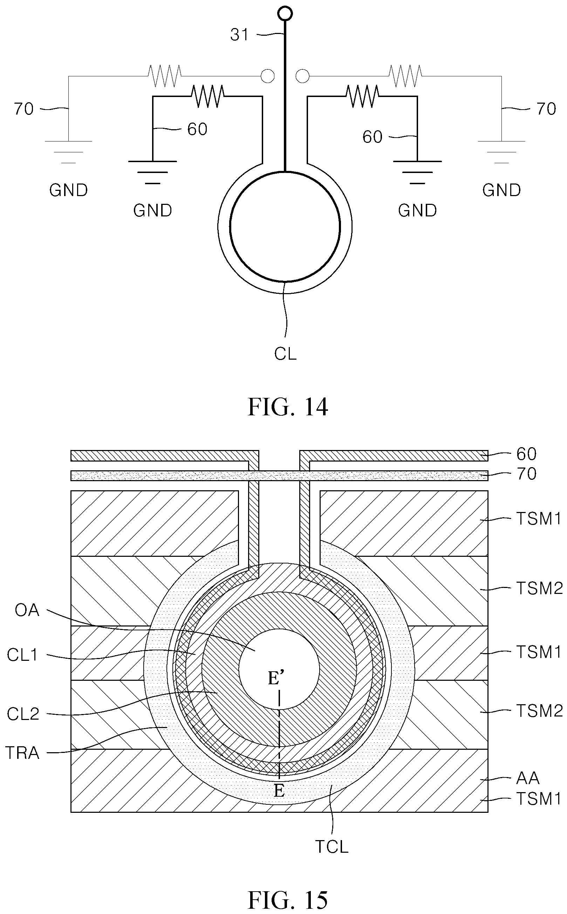

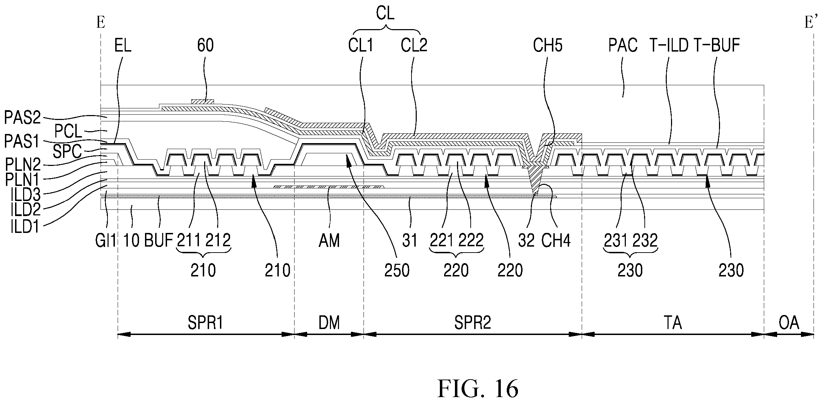

Referring to FIG. 14 to FIG. 16, still another embodiment of the present disclosure will be described. The capping layer CL may be electrically connected to the power connection line 31.

For example, the power connection line 31 may be a high-potential voltage line or a low-potential voltage line.

The power connection line 31 may be disposed under the capping layer CL.

For example, the power connection line 31 may be disposed in the same layer as the first light blocking layer BSM1 and may be made of the same material as that of the first light blocking layer BSM1.

The power connection line 31 may be formed to extend along the first disconnection area SPR1 and the dam area DM and into the second disconnection area SPR2.

A portion of the power connection line 31 positioned in the second disconnection area SPR2 may be electrically connected to the first capping layer CL1 via a fourth contact hole CH4 extending through the buffer layer BUF, the first interlayer insulating layer ILD1, the second interlayer insulating layer ILD2, the third interlayer insulating layer ILD3, the first planarization layer PLN1, the first passivation layer PAS1, and the touch buffer layer T-BUF.

In this case, a power connection electrode 32 may be additionally formed between the power connection line 31 and the first capping layer CL1. Thus, the power connection line 31 may be electrically connected to the first capping layer CL1 via the power connection electrode 32 filling the fourth contact hole CH4.

The fourth contact hole CH4 may be disposed between the second disconnection structures 220 that are adjacent to each other.

Accordingly, the power connection electrode 32 filling the fourth contact hole CH4 may be disposed between the second disconnection structures 220 adjacent to each other.

Therefore, a spacing between the second disconnection structures 220 between which the fourth contact hole CH4 is disposed may be greater than a spacing between the second disconnection structures 220 between which the fourth contact hole CH4 is not disposed.

Additionally, the first capping layer CL1 may be electrically connected to the second capping layer CL2 via a fifth contact hole CH5 extending through the touch interlayer insulating layer T-ILD.

In this case, the fifth contact hole CH5 may be disposed to overlap the fourth contact hole CH4 in the vertical direction.

Accordingly, the second capping layer CL2 may be electrically connected to the power connection line 31 via the first capping layer CL1.

The power connection line 31, the power connection electrode 32, the first capping layer CL1, and the second capping layer CL2 may be sequentially stacked such that adjacent ones thereof may contact each other, such that the insulating layers positioned thereon may cut off.

The crack sensing wiring 60 may be disposed outwardly of the static-electricity prevention wiring 70.

According to an embodiment of the present disclosure, the insulating layer may be discontinuous or cut off due to a structure in which the capping layer CL is connected to the power connection line 31 disposed thereunder via the power connection electrode 32. Thus, this structure may function as an additional crack propagation prevention structure that may block crack propagation through the insulating layer.

Further, according to an embodiment of the present disclosure, the power with a constant voltage may be applied to the capping layer CL extending to surround the open area OA. Thus, the static-electricity generated during the cutting process to form the open area OA may be discharged to the outside such that the occurrence of pixel defects may be reduced.

Further, according to an embodiment of the present disclosure, the power with a constant voltage may be applied to the capping layer CL extending to surround the open area OA. Thus, the voltage of the capping layer CL may be kept constant without changing, thus reducing occurrence of the touch noise in the touch display device.

A display device according to at least one embodiment of the present disclosure as described above may be described as follows.

A first aspect of the present disclosure provides a display device comprising: a substrate including a display area, an open area positioned in the display area, and an intermediate area positioned between the display area and the open area; and a capping layer disposed on the intermediate area of the substrate and extending in a closed loop so as to surround the open area in a plan view of the device, wherein the capping layer includes a metal material, wherein the capping layer is connected to a ground or receives an electrical power having a constant voltage.

According to some embodiments of the first aspect, the display device further comprises a crack sensing wiring or a static-electricity prevention wiring having at least a portion disposed on the intermediate area of the substrate, wherein the capping layer is electrically connected to the crack sensing wiring or the static-electricity prevention wiring connected to the ground, and thus is connected to the ground.

According to some embodiments of the first aspect, the capping layer includes a first capping layer and a second capping layer disposed on top of and spaced apart from the first capping layer, wherein the second capping layer is electrically connected to the crack sensing wiring or the static-electricity prevention wiring via the first capping layer.

According to some embodiments of the first aspect, the display device further comprises a power connection line disposed under the capping layer, wherein the capping layer is electrically connected to the power connection line and thus has a voltage equal to a voltage of the power connection line.

According to some embodiments of the first aspect, the power connection line includes a high-potential voltage line or a low-potential voltage line.

According to some embodiments of the first aspect, the capping layer includes a first capping layer and a second capping layer disposed on top of and spaced apart from the first capping layer, wherein the second capping layer is electrically connected to the power connection line via the first capping layer.

A second aspect of the present disclosure provides a display device comprising: a substrate including a display area, an open area positioned in the display area, and an intermediate area positioned between the display area and the open area; at least one disconnection area disposed on the intermediate area of the substrate; at least one insulating layer disposed to cover the at least one disconnection area; and a capping layer disposed in the intermediate area so as to cover the at least one disconnection area and to surround the open area in a plan view of the device, wherein the capping layer includes a metal material, wherein the capping layer is connected to a ground or receives an electrical power having a constant voltage.

According to some embodiments of the second aspect, the display device further comprises a dam area disposed on the intermediate area of the substrate, wherein the at least one disconnection area includes a first disconnection area disposed between the dam area and the display area, and a second disconnection area disposed between the dam area and the open area, wherein the capping layer is disposed to cover an entirety of each of the second disconnection area and the dam area, and to cover at least a portion of the first disconnection area.

According to some embodiments of the second aspect, the capping layer includes a first capping layer and a second capping layer disposed on top of and spaced apart from the first capping layer, wherein each of the first capping layer and the second capping layer has a closed loop shape in the plan view of the device.

According to some embodiments of the second aspect, the second capping layer has an area size larger than an area size of the first capping layer in the plan view of the device.

According to some embodiments of the second aspect, the display device further comprises a crack sensing wiring or a static-electricity prevention wiring disposed on the intermediate area of the substrate, wherein the first capping layer is electrically connected to the crack sensing wiring or the static-electricity prevention wiring connected to the ground and thus is connected to the ground.

According to some embodiments of the second aspect, the first capping layer and the second capping layer are electrically connected to each other via a contact hole, such that the second capping layer is electrically connected to the crack sensing wiring or the static-electricity prevention wiring via the first capping layer.

According to some embodiments of the second aspect, the display device further comprises: a power connection line disposed under the insulating layer and receiving the power; and a power connection electrode extending through the insulating layer and having one end and the other end respectively connected to the first capping layer and the power connection line, wherein the first capping layer is electrically connected to the power connection line via the power connection electrode.

According to some embodiments of the second aspect, the second disconnection area includes a plurality of disconnection structures arranged in one direction, wherein the power connection electrode is disposed between adjacent ones of the plurality of disconnection structures.

According to some embodiments of the second aspect, the first capping layer is electrically connected to the second capping layer in an area overlapping a contact hole connecting the power connection electrode and the first capping layer to each other in a vertical direction.

According to some embodiments of the second aspect, the power connection line, the power connection electrode, the first capping layer, and the second capping layer are sequentially stacked to cut off the insulating layer.

According to some embodiments of the second aspect, the display device further comprises a touch electrode layer disposed on the substrate and including a first touch electrode and a second touch electrode, wherein the first touch electrode and the first capping layer are disposed in the same layer, wherein the second touch electrode and the second capping layer are disposed in the same layer.

According to some embodiments of the second aspect, the second capping layer extends beyond an end of the first capping layer facing the open area toward the open area so as to cover a side surface of the end of the first capping layer.

Although some embodiments of the present disclosure have been described in more detail with reference to the accompanying drawings, the present disclosure is not necessarily limited to these embodiments, and may be modified in a various manner within the scope of the present disclosure. Accordingly, the embodiments as disclosed in the present disclosure are intended for illustrating rather than limit the technical idea of the present disclosure, and the scope of the technical idea of the present disclosure is not limited by these embodiments. Therefore, it should be understood that the embodiments described above are not restrictive but illustrative in all respects.

## Claims

1. A display device (1) comprising:
a substrate (10) including a display area (AA), an open area (OA) positioned in the display area (AA), and an intermediate area (MA) positioned between the display area (AA) and the open area (OA); and
a capping layer (CL) disposed on the intermediate area (MA) of the substrate (10) and extending in a closed loop so as to surround the open area (OA) in a plan view of the display device (1), wherein the capping layer (CL) includes a metal material,
wherein the capping layer (CL) is connected to a ground (GND) or receives an electrical power having a constant voltage.

2. The display device (1) of claim 1, wherein the display device (1) further comprises a crack sensing wiring (60) or a static-electricity prevention wiring (70) having at least a portion disposed on the intermediate area (MA) of the substrate (10),
wherein the capping layer (CL) is electrically connected to the crack sensing wiring (60) or the static-electricity prevention wiring (70) connected to the ground (GND), and thus is connected to the ground (GND).

3. The display device (1) of claim 2, wherein the capping layer (CL) includes a first capping layer (CL1) and a second capping layer (CL2) disposed on top of and spaced apart from the first capping layer (CL1),
wherein the second capping layer (CL2) is electrically connected to the crack sensing wiring (60) or the static-electricity prevention wiring (70) via the first capping layer (CL1).

4. The display device (1) of claim 1, wherein the display device (1) further comprises a power connection line (31) disposed under the capping layer (CL),
wherein the capping layer (CL) is electrically connected to the power connection line (31) and thus has a voltage equal to a voltage of the power connection line (31).

5. The display device (1) of claim 4, wherein the power connection line (31) includes a high-potential voltage line or a low-potential voltage line.

6. The display device (1) of claim 5, wherein the capping layer (CL) includes a first capping layer (CL1) and a second capping layer (CL2) disposed on top of and spaced apart from the first capping layer (CL1),
wherein the second capping layer (CL2) is electrically connected to the power connection line (31) via the first capping layer (CL1).

7. The display device (1) of claim 1, wherein the display device further comprises:
at least one disconnection area (SPR1, SPR2) disposed on the intermediate area (MA) of the substrate (10); and
at least one insulating layer disposed to cover the at least one disconnection area (SPR1, SPR2), and
wherein a capping layer (CL) covers the at least one disconnection area (SPR1, SPR2).

8. The display device (1) of claim 7, wherein the display device (1) further comprises a dam area (DM) disposed on the intermediate area (MA) of the substrate (10),
wherein the at least one disconnection area (SPR1, SPR2) includes a first disconnection area (SPR1) disposed between the dam area (DM) and the display area (AA), and a second disconnection area (SPR2) disposed between the dam area (DM) and the open area (OA),
wherein the capping layer (CL) is disposed to cover an entirety of each of the second disconnection area (SPR2) and the dam area (DM), and to cover at least a portion of the first disconnection area (SPR1).

9. The display device (1) of claim 7 or 8, wherein the capping layer (CL) includes a first capping layer (CL1) and a second capping layer (CL2) disposed on top of and spaced apart from the first capping layer (CL1),
wherein each of the first capping layer (CL1) and the second capping layer (CL2) has a closed loop shape in the plan view of the display device (1).

10. The display device (1) of claim 9, wherein the second capping layer (CL2) has an area size larger than an area size of the first capping layer (CL1) in the plan view of the display device (1).

11. The display device (1) of claim 9 or 10, wherein the display device (1) further comprises a crack sensing wiring (60) or a static-electricity prevention wiring (70) disposed on the intermediate area (MA) of the substrate (10),
wherein the first capping layer (CL1) is electrically connected to the crack sensing wiring (60) or the static-electricity prevention wiring (70) connected to the ground (GND) and thus is connected to the ground (GND).

12. The display device (1) of claim 11, wherein the first capping layer (CL1) and the second capping layer (CL2) are electrically connected to each other via a contact hole, such that the second capping layer (CL2) is electrically connected to the crack sensing wiring (60) or the static-electricity prevention wiring (70) via the first capping layer (CL1).

13. The display device (1) of any of claims 9 to 12, wherein the display device (1) further comprises:
a power connection line (31) disposed under the at least one insulating layer and receiving the power; and
a power connection electrode (32) extending through the at least one insulating layer and having one end and the other end respectively connected to the first capping layer (CL1) and the power connection line (31),
wherein the first capping layer (CL1) is electrically connected to the power connection line (31) via the power connection electrode (32).

14. The display device (1) of claim 13, wherein the second disconnection area (SPR2) includes a plurality of disconnection structures (220) arranged in one direction,
wherein the power connection electrode (32) is disposed between adjacent ones of the plurality disconnection structures (220).

15. The display device (1) of claim 13 or 14, wherein the first capping layer (CL1) is electrically connected to the second capping layer (CL2) in an area overlapping a contact hole connecting the power connection electrode (32) and the first capping layer (CL1) to each other in a vertical direction.
